# EUROPÄISCHE PATENTSCHRIFT

(11) **EP 1 255 876 B1**
(45) Veröffentlichungstag und Bekanntmachung des Hinweises auf die Patenterteilung: **30.07.2003**
(21) Anmeldenummer: 01903774.6
(22) Anmeldetag: 15.02.2001
(51) Int. Cl.: C23C 16/448, C23C 16/46, C23C 16/52

(54) **KONDENSATIONSBESCHICHTUNGSVERFAHREN**
CONDENSATION COATING METHOD
PROCEDE DE PRODUCTION DE REVETEMENT PAR CONDENSATION

(30) Priorität: 16.02.2000 DE 10007059
(43) Veröffentlichungstag der Anmeldung: 13.11.2002
(73) Patentinhaber: Aixtron AG, 52072 Aachen (DE)
(72) Erfinder: JÜRGENSEN, Holger, 52072 Aachen (DE); KÄPPELER, Johannes, 52146 Würselen (DE); STRAUCH, Gert, 52072 Aachen (DE); SCHMITZ, Dietmar, 52072 Aachen (DE)
(74) Vertreter: Grundmann, Dirk, Dr.
(86) Internationale Anmeldenummer: EP0101698
(87) Internationale Veröffentlichungsnummer: WO01061071

(56) Entgegenhaltungen:
- EP-A- 0 548 944
- EP-A- 0 635 460
- US-A- 5 186 410
- US-A- 5 381 605
- US-A- 5 496 410
- US-A- 5 776 254
- US-A- 5 882 410
- US-A- 5 989 635

## Beschreibung

### Technisches Gebiet

Die Erfindung bezieht sich auf ein Verfahren und eine Vorrichtung zur Herstellung von Schichtsystemen, wie z.B. für Dünnfilmbauelemente wie OLED's oder ähnliche Schichtstrukturen mittels Kondensationsbeschichtung. Diese Schichtsysteme bestehen insbesondere aus organischen Materialien, wie z.B. "small molecules" (z.B. Alq₃) oder Polymeren (z.B. PPV).

### Stand der Technik

Kondensationsbeschichtungsverfahren zur Herstellung von Bauelementen insbesondere aus organischen Materialien sind bekannt. Bei diesem Verfahren werden die Bestandteile der herzustellenden Schicht mittels gasförmigen und/oder organischen Verbindungen (Salze) in die Beschichtungskammern (im Folgenden als Reaktionskammer bezeichnet) transportiert.

Die Beschichtung des Substrates (meist Glas, Folie oder Kunststoffe) erfolgt auf der Basis des Kondensationsprozesses, wobei die Substrate auf einer Temperatur gehalten werden, die niedriger ist, als die Temperatur der sich in der Gasphase befindlichen Moleküle.

VPD-Verfahren (Vapor Phase Deposition) werden zur Abscheidung unterschiedlicher Materialien aus der Gasphase verwendet. Auch im Bereich der Abscheidung von organischen Schichten hat sich dieses Verfahren durchgesetzt. Das VPD-Verfahren wird mit unterschiedlichen Reaktorkonzepten kontrolliert, z.B.:
Horizontale Rohrreaktoren, in denen die Gasströmung horizontal und parallel zur Beschichtungsoberfläche verläuft, (den klassischen VPE Reaktoren entlehnt). Zur Vermeidung von Effizienz reduzierender Wandkondensation werden die Reaktoren als Heißwandsystem ausgelegt.

Dieses Verfahren bzw. diese bekannte Vorrichtung wird zur Beschichtung von meist flachen und nicht variablen Substratgeometrien eingesetzt.

Die Nachteile liegen in
- a): der verfahrenstechnischen und geometrischen Verkoppelung der Prekursor-Sublimation und deren Einleitung,
- b): der Verwendung von Reaktorgeometrien mit großer Systemoberfläche im Verhältnis zur Beschichtungsoberfläche, d.h. hydrodynamisch geht eine große Menge von Prekursoren der Beschichtung auf dem Substrat verloren
- c): aus b) folgend teuerer Heißwandtechnik.

In Aufdampfanlagen, deren Verfahrensprinzip der Kondensation entspricht, sind die Quellmaterialien im System integriert, d.h. der Quellenstrom ist zeitlich nicht kontrollierbar. Er kann nicht schlagartig an- oder abgeschaltet werden. Die zeitliche Kontrolle geschieht hier über die Steuerung der Verdampfungsenergie (E-Beam oder Widerstandsheizung). Ferner sind die Systeme nicht als Heißwandsysteme ausgebildet, so dass ein wesentlicher Anteil der Materialien an den Systemwänden und Komponenten Effizienz mindernd kondensiert.

Die Nachteile dieser Technik liegen auch in der schlechten Kontrollierbarkeit von Stöchiometrie oder von scharfen Übergängen für Mehrschichtanforderungen.

Im CVD System sind die Quellen individuell zeitlich und in der Menge präzise kontrollierbar, jedoch ist der Transport aus einer Quelle nicht das Prinzip der Sublimation, sondern das der Verdampfung. In diesen CVD-Systemen ist das Beschichtungsverfahren nicht Kondensation, sondern kinetisch oder diffusionslimitiertes Wachstum (chemische Reaktion). Diese Verfahren und Vorrichtungen werden zur Beschichtung von meist flachen und nicht variablen Substratgeometrien eingesetzt.

Alternative Verfahren sind Spin on oder OMBD.

Die oben beschriebenen Verfahren und Vorrichtungen erfüllen in einer oder mehreren Eigenschaften nicht die Anforderung zur Herstellung der beispielhaft aufgeführten Schichtsysteme im Hinblick auf präzise Kontrolle der Stöichiometrie und Mehrschichtanforderung sowie der Wirtschaftlichkeit.

Der Erfindung liegt die Aufgabe zugrunde, das gattungsgemäße Verfahren dahingehend zu verbessern, dass die Parameter individualisierter vorgebbar sind, dass die Effizienz erhöht ist, und die Qualität der auf dem Substrat kondensierten Schichten zu erhöhen.

Gelöst wird die Aufgabe durch die in den Ansprüchen angegebene Erfindung. Die Unteransprüche stellen vorteilhafte Weiterbildungen der Erfindung dar.

Die Verwendung einer Kombination von spezieller Prekursorsublimation, Verdampfung, Gaseinlassgeometrie und Reaktorgeometrie für das Beschichtungsverfahren verbessert die Kontrolle und Wirtschaftlichkeit des Verfahrens zur Kondensationsbeschichtung ausgehend von festen Prekursoren. Dabei werden die Prekursoren individuell und außerhalb der Reaktionskammer sublimiert bzw. verdampft. Diese Ausgangsstoffe können auf dem Substrat selektiv kondensieren. Mittels einer dem Substrat zugeordneten Maske kann eine Strukturierung erfolgen. Die Maske kann auf dem Substrat befestigt werden.

Allen Reaktorkonzepten gemein ist, dass die Art der Prekursor-Sublimation nach deren Gaseinspeisung in das Reaktionsgefäß dabei maßgeblich die Gasphasenchemie der Elementsubstanzen als auch deren Transportverhalten bestimmt und damit die Eigenschaften der abgeschiedenen Schichten, d.h. die Art der Gaseinspeisung dominiert die Verfahrenskontrolle.

Diese Eigenschaften sind z.B. (d.h. frei von Fremdatomen/Stoffen), Partikel und/oder Defektdichte, Zusammensetzung im Mehrstoffsystem, optische und elektrische Eigenschaften der Schichten sowie Effizienz der Deposition. Die nach Stand der Technik eingesetzten Gaseinlassgeometrien erfüllen entweder nur die hydrodynamische oder die thermodynamische Aufgabenstellung.

Oft erfolgt eine ungewollte Deposition im Bereich der Einlassgeometrie. Diese entsteht dann, wenn im Einlassbereich entweder zu hohe (d.h. kinetisch limitierte Deposition) oder zu kalte Oberflächentemperaturen (d.h. Kondensation oder Thermophorese) sich einstellen, oder eine Durchmischung der Gase innerhalb der Zone der Einleitung oder innerhalb der Kammer durch Strömung und/oder Diffusion auftritt (Nukleation = homogene Gasphasenreaktion). Die parasitäre Belegung hat dann zur Folge, dass sich die Eigenschaften (thermisch und/oder chemisch) des Gaseinlasses im Laufe des Prozesses ändern, so dass die Kontrolle über eine kontinuierliche und gleichmäßige Abscheidung nicht gewährleistet ist. Die parasitären Ablagerungen führen zu einer Verschleppung einzelner Komponenten in die nachfolgenden Schichten hinein. Ferner reduziert diese Belegung die Effizienz der Elemente, besonders wenn die Einlassgeometrie eine im Vergleich zur Nutzfläche und große Oberfläche aufweist.

Weiterhin ist die Gaseinlasseinheit typisch so gestaltet, dass die effektive Trennung der Gase, die die thermisch unterschiedlichen Eigenschaften der Prekursoren erfordert, nicht gewährleistet ist. Die Folge sind unerwünschte Reaktionen einiger Gase in der Gasphase miteinander (d.h. Nukleation), welche die Eigenschaft der abzuscheidenden Schicht negativ beeinflusst, z.B. Partikel oder Kontamination. Die Nukleation reduziert die Materialeffizienz und führt zur Kontamination der Schicht mit diesen Verbindungen.

Um die oben aufgeführten Nachteile zu reduzieren, werden heutige Gaseinlässe typischerweise prozesstechnisch weit von den zu beschichtenden Oberflächen entfernt angeordnet, d.h. entweder räumlich oder durch Wahl der Prozessparameter (z.B. sehr niedrigen Druck bzw. große Reynold Zahlen). Die derzeit bekannten Reaktoren zeichnen sich daher durch eine niedrige Effizienz (deutlich kleiner als 25%), d.h. nur ein geringer Anteil der eingeleiteten Elemente deponieren in der brauchbaren funktionalen Schicht.

Somit sind die Schichteigenschaften, hergestellt mit solchen Systemen, nicht optimal und auch die Wirtschaftlichkeit solcher Systeme ist nur gering.

Zur Sublimation der festen Prekursoren werden überlicherweise Verdampferquellen verwendet, die durch die Wahl des Behälterdrucks und Temperatur das Quellenmaterial aus der festen Phase direkt gasförmig zur Verfügung stellen, d.h. sublimieren. Ist der Dampfdruck des Quellenmaterials sehr niedrig, werden hohe Temperaturen erforderlich. Nach heutigem Stand der Technik werden daher einige Prekursoren in Booten in den Reaktor eingeführt. In den verwendeten Heißwandsystemen wird die Temperatur der Reaktoren so über die Baulänge profiliert, dass die erforderliche Sublimationstemperatur je Prekursor in je einer Zone eingestellt wird. Nachteil dieses Aufbaus sind ungenaue Einstellung der optimalen Sublimationstemperatur, große Volumina der Verdampfer-Einrichtung, nicht getrennte Druckeinstellung je Prekursor verschieden und unabhängig vom Reaktor-Prozessdruck, nicht flexible und individuelle Temperatureneinstellung je Prekursor. Gravierendster Nachteil jedoch ist der zeitlich nicht gesteuerte Quellenstrom, da diese Verdampferquellen offen zur Beschichtungszone wirken.

Die hier vorgestellte technische Lehre soll alle oben genannten Nachteile beheben und stellt je nach Anwendungsanforderung die geeigneten Verfahren und Vorrichtungen zur Verfügung.

Die Sublimationsvorrichtung der Ausgangsstoffe (Prekursoren) ist geometrisch vom Reaktor getrennt und je Prekursor einzeln ausgeführt. Damit kann flexible und optimiert die Transportmenge je Prekursor kontrolliert und gesteuert werden. Jeder Prekursor ist individuell, zeitlich präzise steuerbar, und zudem unabhängig von Reaktorparametern.

Die Einlassgeometrie sichert minimale Kammeroberfläche im Verhältnis zur Beschichtungsoberfläche (nahe 1:1) und damit maximierte Effizienz des Verfahrens. Die Ausgestaltung der Geometrie des Einlasses vermeidet im Grundsatz Reaktionen zwischen den Prekursoren als auch parasitäre Belegung an der Oberfläche des Einlasses selber.

Die Ausgestaltung der Einlassgeometrie der Prekursoren in Verbindung mit der Reaktorgeometrie sichert homogene Verteilung aller Materialien mit zeitlich präziser Kontrolle.

Die erzielten Beschichtungen zeichnen sich dabei durch eine Homogenität der Zusammensetzung, Sichtdicke und Dotierung im Bereich von 1% aus. Weiterhin können mit der Apparatur und dem Verfahren Übergänge im Material und Dotierstoffprofile präzise und reproduzierbar eingestellt werden. Die Bildung von Partikel ist durch die Erfindung vermieden.

Der Ort der Sublimation der Ausgangsstoffe (Prekursoren) ist getrennt von der Reaktorkammer ausgeführt. Dabei ist die Anordnung so gewählt, dass der Ausgangsstoff mit minimaler Transiente in den Gaseinlass geführt wird. Hierzu wird in einem Beschichtungssystem der Ausgangsstoff-Behälter in unmittelbarer Nähe z.B. auf den Reaktordeckel platziert. Ein kurzer Rohrweg leitet das Material unmittelbar in die Gaseinlasseinheit.

Der Tank für die Ausgangsstoffe wird eigens und unabhängig von der Reaktortemperatur geheizt. Dazu wird entweder eine Widerstandsheizung um den Tank genutzt, oder in einem Hohlmantel um den Tank thermostatisierte Flüssigkeit gepumpt.

Der Druck im Tank kann mit einem Regelventil an der Ausgangsseite des Tanks einzeln und unabhängig vom Reaktor geregelt werden. Das Regelventil ist beheizt und stellt im Verlauf des Materialweges einen positiven Temperaturgradienten zur Vermeidung von lokaler Kondensation sicher.

Der Transport des sublimierten Ausgangsstoffes zum Reaktor wird mittels eines Gasflusses unterstützt. Dieses Gas wird auch zur Einstellung einer Prekursorkonzentration in der Zuleitung verwendet.

Zur zeitlichen Kontrolle der Leitung der Ausgangsstoffe in den Reaktor wird das Druckventil und der Massenflussregler geregelt, d.h. schließt das Drosselventil vollständig, wird der Massenfluss auf 0 gesetzt.

Diese Anordnung kann auf dem Reaktor in vielfacher Weise wiederholt werden, so dass jedes Material unabhängig voneinander geregelt wird.

Der Gaseinlass wird gegenüber dem Substrat im Reaktor als eine Anordnung von vielen Düsen (im Folgenden Showerhead) aus einer Fläche ausgeführt, im Folgenden Plenum benannt. Die Düsen sind so dimensioniert, dass sie entsprechend der Prekursoreigenschaft, wie Viskosität, Masse und Konzentration eine turbulenzfreie Injektion in die Kammer gewährleisten.

Der Abstand von Düse zu Düse ist im Verbältnis des Abstands zum Gaseinlass optimiert, d.h. die aus den Düsen austretende "Strahlen" (Jets) sind von der Substratoberfläche abgeklungen und bilden im Gesamten eine homogene Strömungsebene.

Die Düsen können einzeln oder gesamt in beliebigem Winkel in der Gaseinlassoberfläche ausgeführt werden, um die Transportverteilung der Ausgangsstoffe homogen für die Form des Substrats zu kontrollieren.

Die Ebene in der die Düsen zur Injektion der Ausgangsstoffe eingebracht sind, kann plan sein für die Beschichtung von planen Substraten und auch Folien oder gewölbt für nicht ebene, d.h. vorgeformte Substrate.

Das gesamte Plenum wird aktiv mittels Kühlmittel in einem Hohlwandaufbau oder mittels einer elektrischen Heizung (Widerstandsheizung, Peltier), so thermisch kontrolliert, dass ein positiver Temperaturgradient gegenüber der Sublimationstemperatur eingestellt wird.

In das Innenvolumen des Plenums wird der sublimierte Ausgangsstoff über eine sehr kurze temperierte Leitung injiziert.

Zur Einstellung der optimierten hydrodynamischen Bedingungen an den Düsen wird zusätzlich zu den Ausgangsstoffen über eine weitere Zuleitung Trägergas eingestellt.

Dieses Gas sichert ferner eine schnelle Spülung des Plenums zum zeitlich kontrollierten An- und Abschalten des Prekursors in die Kammer.

Die beschriebene Anordnung wird für die Mehrstoffanwendung konsequent je Prekursor ausgeführt. Dabei wird unter Nutzung der "closed coupled showerhead"-Technik die separate Injektion je Prekursor gesichert. Durch eine individuelle Heizung jedes Plenums wird jeder Ausgangsstoff entlang eines positiven Temperaturgradienten zur Vermeidung von parasitärer Kondensation kompariert. Die Düsen sind so dimensioniert und zueinander angeordnet, dass keine lokale Mischung der Prekursor an den Düsen entsteht. Die Anordnung der Pleni in Ebenen wird so gewählt, dass die längeren Düsen im thermischen Kontakt mit den folgenden Pleni einen positiven Temperaturgradienten zur Vermeidung der Kondensation dieses Prekursors erhält.

Als Ausgangsstoffe kommen insbesondere solche Salze in Betracht, die das US-Patent 5,554,220 beschreibt. Diese Salze werden in Verdampfern sublimiert. Die Verdampfer können dabei insbesondere eine Gestalt aufweisen, wie sie die deutsche Patentanmeldung DE 100 48 759 beschreibt. Dort wird das Gas unterhalb einer Fritte, auf der sich das Salz in Form einer Schüttung befindet, dem Verdampfer zugeleitet. Oberhalb der Fritte bzw. der Schüttung wird das mit dem gasförmigen Ausgangsstoff gesättigte Gas abgeleitet. Durch eine entsprechend höhere Temperatur der stromabwärts liegenden Rohre oder durch Verdünnung wird der Partialdruck des Ausgangsstoffes unterhalb seines Sättigungspartialdruckes gehalten, so dass eine Kondensation vermieden ist.

Ausführungsbeispiele der Erfindung werden nachfolgend anhand beigefügter Zeichnungen erläutert. Es zeigen:
- Figur 1: in grobschematischer Darstellung eine Vorrichtung gemäß der Erfindung,
- Figur 2: ebenfalls in grobschematischer Darstellung eine Gaseinlasseinheit, welche in einer Vorrichtung gemäß Figur 1 Verwendung finden kann,
- Figur 3: einen Schnitt gemäß der Linie III-III durch die Gaseinlasseinheit,
- Figur 4: einen Schnitt gemäß der Linie IV-IV durch die Gaseinlasseinheit,
- Figur 5: ein zweites Ausführungsbeispiel einer Vorrichtung in einer grobschematischen Darstellung,
- Figur 6: ein zweites Ausführungsbeispiel der Gaseinlasseinheit,

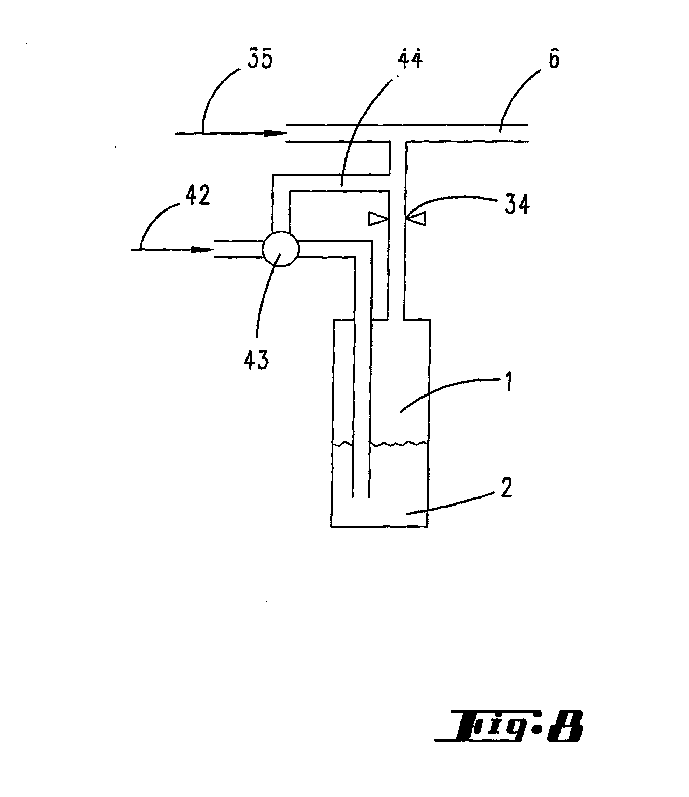

- Figur 7: eine Erläuterungshilfe für die Prozessparameter, und
- Figur 8: in schematischer Darstellung eine Quelle für einen Ausgangsstoff.

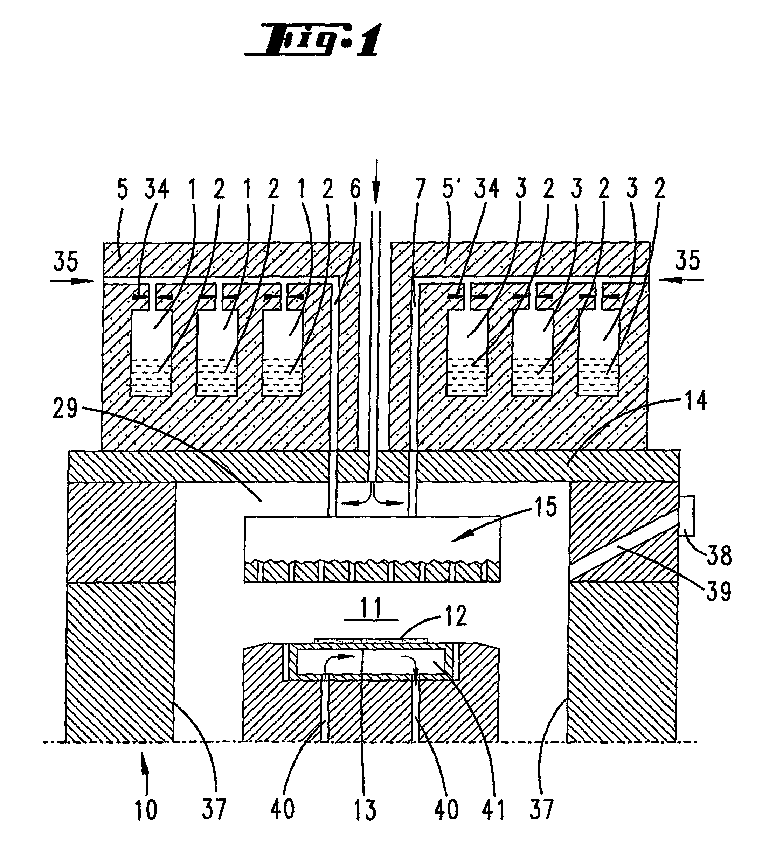

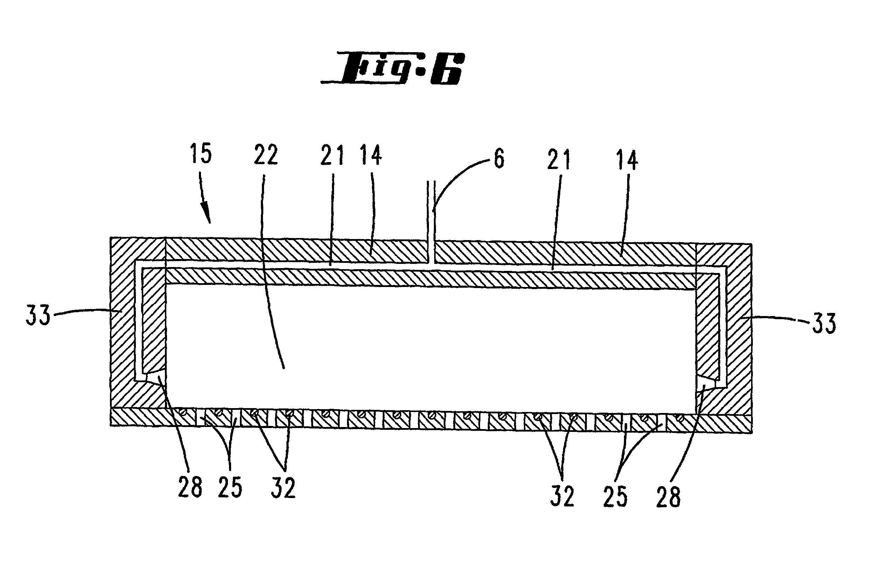

Die in den Figuren 1 und 5 dargestellten Vorrichtungen besitzen jeweils zwei temperierte Behälter 5, 5'. Bei der in Figur 1 dargestellten Vorrichtung sind diese Behälter unmittelbar auf dem Deckel 14 des Reaktors 10 angeordnet. Bei dem in Figur 5 dargestellten Ausführungsbeispiel sind die beiden Behälter 5, 5' etwas entfernt vom Reaktor 10 angeordnet. In den Behältern 5, 5' befinden sich Tanks 1, 3. Diese Tanks wirken als Quelle für die Ausgangsstoffe. In den Tanks 1, 3 befinden sich flüssige Ausgangsstoffe 2, 4. Die Ausgangsstoffe können auch fest sein. Im Innern der temperierten Behälter 5, 5' herrscht eine derartige Temperatur, dass die in den Tanks 1, 3 befindlichen Ausgangsstoffe 2, 4 verdampfen. Die Verdampfungsrate lässt sich über die Temperatur beeinflussen. In dem Behälter 5 sind im Ausführungsbeispiel drei Quellen und im Behälter 5' sind ebenfalls drei Quellen angeordnet. Die beiden Behälter 5, 5' können auf unterschiedlichen Temperaturen gehalten werden.

In jeden der beiden Behälter 5, 5' führt eine Trägergasleitung, um ein Trägergas 35 zu leiten. In die Trägergasleitung münden je Quelle eine Ableitung für die aus den Tanks 1, 3 heraustretenden gasförmigen Ausgangsstoffe. Die Tanks 1, 3 sind mittels hitzebeständiger Ventile, insbesondere Regelventile 34, die auch selbst beheizt sein können, verschließbar und öffenbar. Die Leitungen 6, 7, durch welche das Trägergas und die vom Trägergas transportierten Reaktionsgase strömen, münden beim Ausführungsbeispiel der Figur 1 direkt in den Reaktor. Beim Ausführungsbeispiel gemäß der Figur 5 verlaufen die beiden Leitungen 6, 7 über eine freie Strecke, wo sie mittels temperierter Mäntel 8, 9 auf einer Temperatur gehalten werden, die gleich oder größer ist, als die Temperatur in den Behältern 5, 5'. Die Leitungen 6, 7 münden in den Reaktor. Die Dosierung der Reaktionsgase erfolgt über die Temperatur der Behälter 5, 5' bzw. die Regelventile 34.

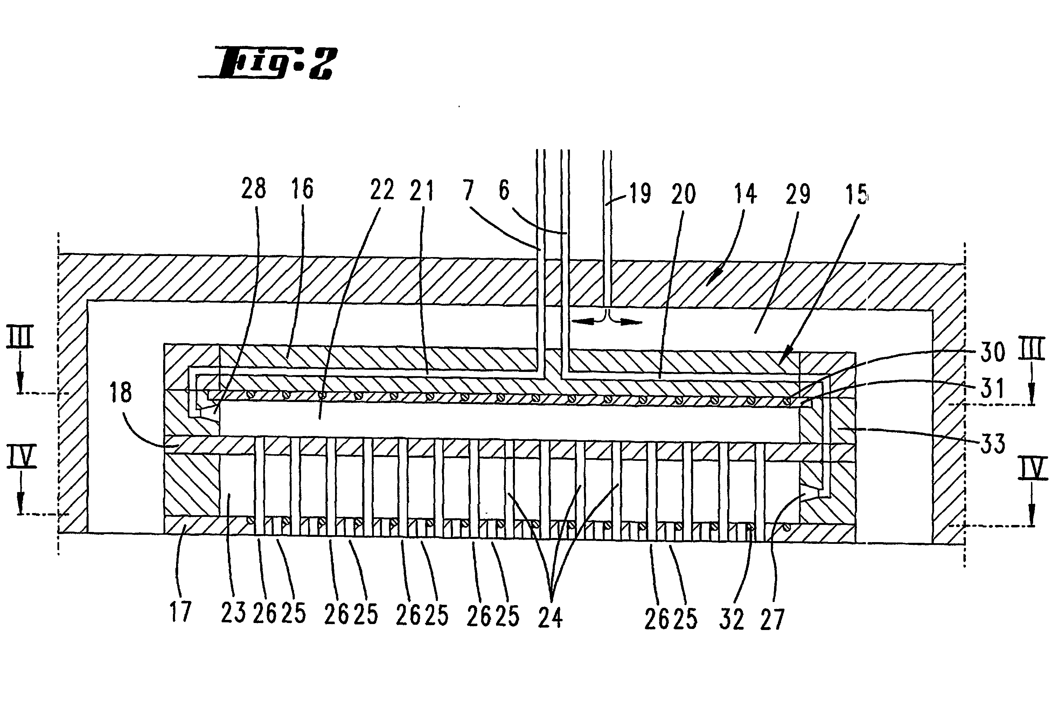

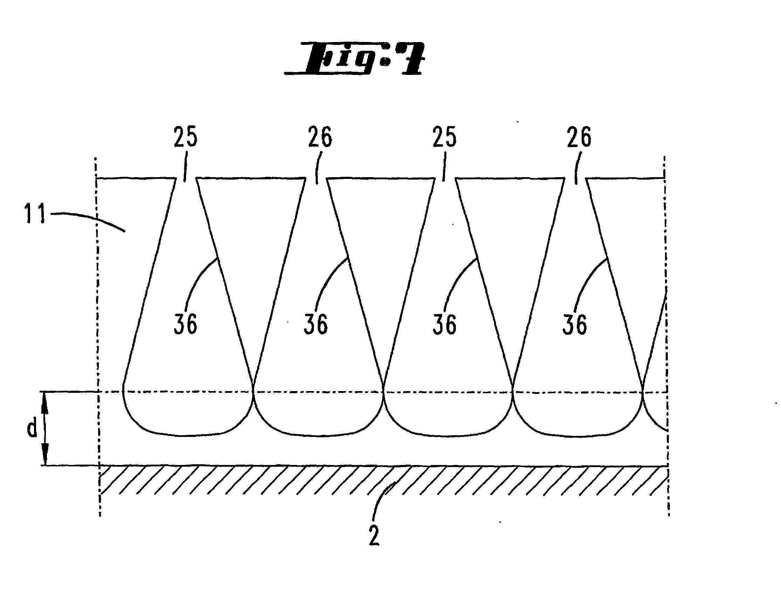

Im Bereich der Mündung der Leitungen 6, 7 besitzt der Reaktordeckel 14 eine Temperatur, die größer ist, als die Temperatur in den temperierten Behältern 5, 5'. Die Leitungen 6, 7 münden nicht unmittelbar in die Reaktionskammer 11, sondern zunächst in eine in der Reaktionskammer, um einen Spalt 29 vom Reaktordeckel 14 beabstandete Gaseinlasseinheit 15. Eine typisch gestaltete Gaseinlasseinheit zeigen die Figur 2 und 6.

Die Gaseinlasseinheit 15 befindet sich unmittelbar oberhalb des Substrates 12. Zwischen dem Substrat 12 und der Bodenplatte 17 der Gaseinlasseinheit 15 befindet sich die Reaktionskammer. Das Substrat 12 liegt auf einem Suszeptor 13, welcher gekühlt ist. Die Temperatur des Suszeptors wird geregelt. Hierzu kann der Suszeptor mit Pelletierelementen versehen sein. Es ist aber auch möglich, wie in Figur 1 dargestellt, dass der Suszeptor 13 innen eine Hohlkammer 41 besitzt, die mittels Spülleitungen 40 mit einer Kiahlflüssigkeit gespült wird, so dass damit die Temperatur des Suszeptors 13 auf einer Temperatur gehalten werden kann, die geringer ist, als die Temperatur der Gaseinlasseinheit 15.

Diese Temperatur ist auch geringer, als die Temperatur der Reaktorwände 37. Die Temperatur der Gaseinlasseinheit 15 liegt oberhalb der Kondensationstemperatur der gasförmig in die Gaseinlasseinheit 15 gebrachten Ausgangsstoffe 2, 4. Da auch die Temperatur der Reaktorwände 37 höher ist, als die Kondensationstemperatur, kondensieren die aus der Gaseinlasseinheit 15 austretenden Moleküle ausschließlich auf dem auf dem Suszeptor 13 aufliegenden Substrat 12.

Bei den in den Figuren 2 bzw. 6 dargestellten Gaseinlasseinheiten 15 handelt es sich jeweils um einen sogenannten, an sich bekannten "Showerhead". Das Ausführungsbeispiel der Figur 2 zeigt einen Showerhead mit insgesamt zwei voneinander getrennten Volumen 22, 23. Die Volumen sind mittels einer Zwischenplatte 18 gegeneinander und mittels einer Deckplatte 16 bzw. einer Bodenplatte 17 gegenüber der Reaktionskammer 11 abgegrenzt. Der "Showerhead" gemäß Figur 6 besitzt dagegen nur eine Kammer. Dieses Volumen 22 wird begrenzt von der Bodenplatte 17, einem Ring 33 und der Deckplatte 16. In die Deckplatte 16 münden die bereits erwähnten Rohrleitungen 6, 7 für die beiden Ausgangsstoffe. Beim Ausführungsbeispiel gemäß Figur 6 ist nur eine Rohrleitung 6 erforderlich. Die Rohrleitungen 6 bzw. 7 münden in sternförmig radial verlaufende Kanäle 21 bzw. 20, die in der Deckplatte 16 angeordnet sind. Nach einer Umleitung im Randbereich des im Wesentlichen zylinderförmigen Körpers der Gaseinlasseinheit 15 münden die Kanäle 20 bzw. 21 in radial außen liegende Mündungstrichter 27 bzw. 28, die sich an der äußeren Peripherie der zylinderförmigen Volumina 22, 23 befinden. Die aus den Mündungstrichtern 27, 28 austretenden Gase verteilen sich in den Volumina 22, 23 gleichmäßig.

Die in einem Mehrkammer-Showerhead vorgesehene Zwischenplatte 18 besitzt Öffnungen, von welchen Röhrchen 24 ausgehen, die das Volumen 23 durchragen und mit der Bodenplatte 17 derart verbunden sind, dass das im Volumen 22 befindliche Gas nicht in Kontakt tritt, mit dem im Volumen 23 befindlichen Gas. In der Bodenplatte 17 befinden sich abwechselnd zu den Öffnungen 26 der Röhrchen 24 Öffnungen 25, aus welchen das in dem Volumen 23 befindliche Gas austreten kann.

Die in den Volumen 22, 23 befindlichen Gase treten durch die düsenartig ausgebildeten Öffnungen 25, 26 in einem homogenen Strömungsfeld aus.

Aus den Öffnungen 25, 26 treten die Gase turbulent aus. Sie foxmen jeweils einen Strahl, so dass sich die aus nebeneinander liegenden Öffnungen 25, 26 austretenden Gasströme erst unmittelbar oberhalb des Substrates 12 innerhalb der in der Figur 6 mit d bezeichneten Grenzschicht mischen. Oberhalb der Grenzschicht d verlaufen die Strahlen 36 im Wesentlichen parallel zueinander, ohne dass zwischen ihnen eine nennenswerte Durchmischung stattfindet. Im Abstand d ist eine nahezu homogene Gasfront ausgebildet.

Bei dem in Figur 2 dargestellten Ausführungsbeispiel sind die beiden Volumina 22, 23 unabhängig voneinander thermostatierbar. Bei dem in Figur 6 dargestellten Ausführungsbeispiel ist das einzige Volumen 22 thermostatierbar. Um die Volumina 22, 23 auf eine voreingestellte Temperatur zu regeln, die größer ist, als die Temperatur der Behälter 5, 5' und erheblich größer, als die Temperatur des Suszeptors 13, sind Heizwendel 30, 32 vorgesehen. Anstelle der Heizwendel 30, 32 ist es aber auch denkbar, Kanäle in die Platten 17, 18, 16 einzubringen, und diese von einer temperierten Flüssigkeit durchströmen zu lassen.

Der Ring 33 kann in einer ähnlichen Weise beheizt werden. Dem Ring können in geeigneter Weise Heizwendel angeordnet sein. Er kann aber auch mit entsprechend temperierten Flüssigkeiten auf Temperatur gehalten werden.

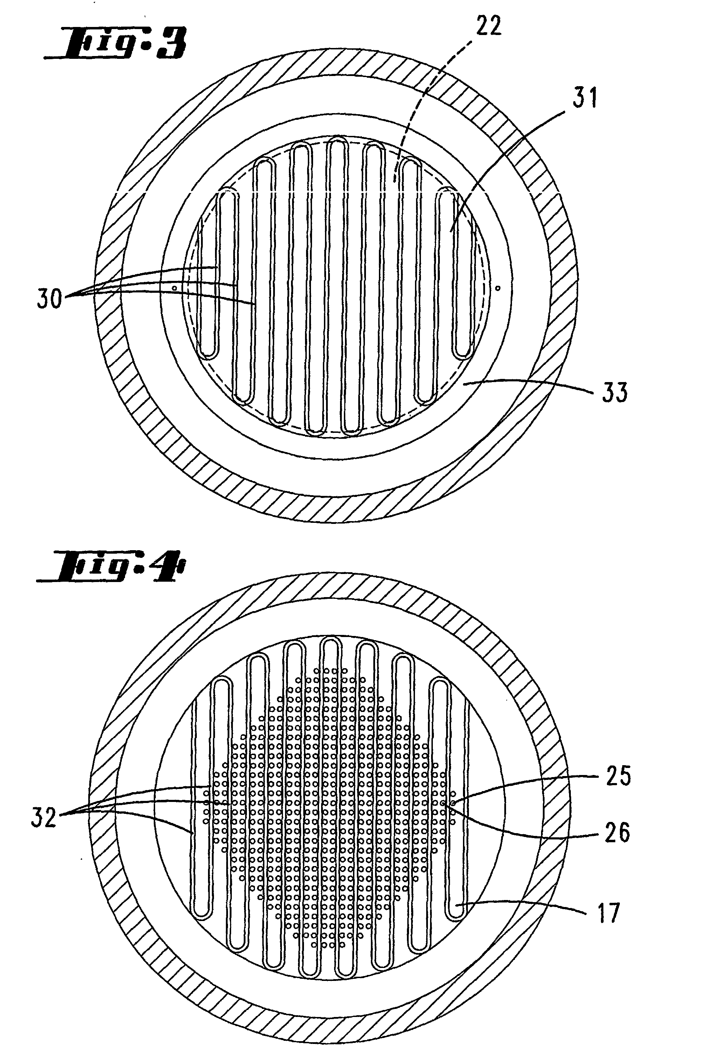

Beim Ausführungsbeispiel befindet sich unterhalb der Deckplatte 16 eine Heizplatte 31. Der Figur 3 ist zu entnehmen, dass in der Heizplatte 31 mäanderförmig eine Heizwendel 33 eingebracht ist. Auch die Deckplatte der Gaseinlasseinheit 15 der Figur 6 kann beheizt sein.

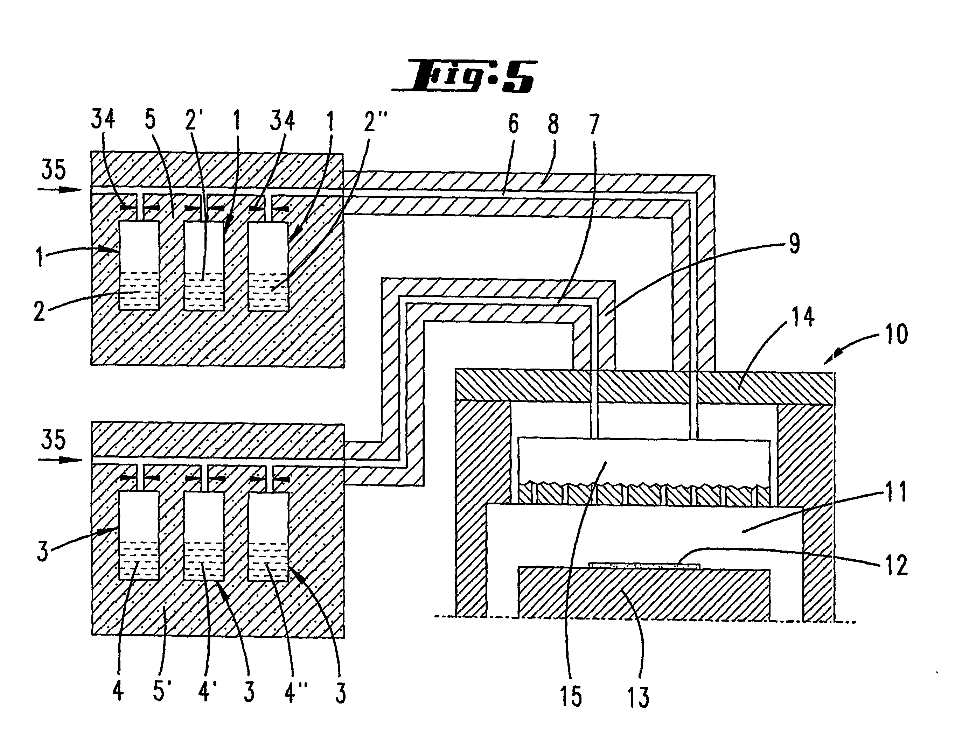

Auch in die Bodenplatte 17 ist eine Heizwendel 33 mäanderförmig eingebracht. (vgl. Fig. 4)

Als Ausgangsstoffe für die Beschichtung können solche Salze verwendet werden, wie das US-Patent 5,554,220 beschreibt. Diese Salze werden in Tanks sublimiert, indem den Tanks ein Trägergas zugeleitet wird, welches durch eine Schüttung der Salze strömt. Ein derartiger Verdampfer wird in der DE 100 48 759.9 beschrieben.

Die Figur 8 zeigt ferner exemplarisch einen Verdampfer für eine Flüssigkeit. Ein Trägergas 42 wird durch ein Dreiwegeventil über eine Zuleitung in den flüssigen oder festen Ausgangsstoff 2 eingeleitet. Es durchströmt dann den Ausgangsstoff 2, um durch die Austrittsleitung und das geheizte Ventil 34 den Tank 1 zu verlassen.
Über eine Rohrleitung 6. wird es mittels des Trägergases 35 der Gaseinlasseinheit 15 zugeführt. Die Spülung des Tanks mit dem Trägergas 42 kann mittels des Dreiwegeventiles an- und abgeschaltet werden. Im abgeschalteten Zustand strömt das Trägergas 42 durch eine Bypassleitung 44 direkt in die Ableitung bzw. die Rohrleitung 6. Der Gasfluss 42 und der Gasfluss 35 sind massenflussgeregelt. Um den Massenfluss 42 beim Umschalten des Dreiwegeventiles 43 nicht zu beeinflussen, kann die Bypassleitung 44 den selben Strömungswiderstand besitzen, wie der gesamte Tank 1.

Jeder der in den Figuren 1 bzw. 5 angedeutete Tank 1, 3 kann eine Gestaltung und eine Beschaltung haben, wie sie in Figur 8 dargestellt ist oder wie sie in der DE 100 48 759.9 beschrieben wird.

Zufolge der Verdünnung die durch das Trägergas 35 erzielt ist, sinkt der Partialdruck des Ausgangsstoffes 2 bzw. des Ausgangsstoffes 3 innerhalb des den Tanks 1, 3 folgenden Rohrleitungssystems bzw. der Gaseinlasseinheit 15. Diese Verdünnung hat zur Folge, dass die Temperatur in diesen nachfolgenden Rohrabschnitten 6, 7 bzw. in der Gaseinlasseinheit 15 geringer sein kann, als die Temperatur in den Behältern 5, 5', ohne dass eine Kondensation eintritt, da die Temperatur immer noch so hoch ist, dass der Partialdruck der einzelnen Ausgangsstoffe unterhalb ihres Sättigungsdampfdruckes liegt.

Mittels eines oder mehrerer Sensoren 38; die insbesondere außerhalb der Reaktorwand angeordnet sind und die über einen Kanal 39 mit der Reaktionskammer 11 verbunden sind, kann die Substrattemperatur gemessen werden.

Das in dem Spalt 29 eingeleitete Gas kann durch Wahl einer geeigneten Zusammensetzung in seiner Wärmeleitfähigkeit variiert werden. Durch die Wahl der Gaszusammensetzung kann demnach der Wärmetransport von oder zur Gaseinlasseinheit 15 eingestellt werden. Auch auf diese Weise lässt sich die Temperatur beeinflussen.

## Patentansprüche

1. Verfahren zum Beschichten von Substraten, bei dem in einer Reaktionskammer mittels eines Kondensationsverfahrens durch Einleiten von Reaktionsgasen durch eine Gaseinlaßeinheit (15) in die Reaktionskammer auf das wenigstens eine von einem Suszeptor getragenen Substrat eine Schicht aufgebracht wird, und bei dem für wenigstens einen Teil der Reaktionsgase feste und/oder flüssige Ausgangsstoffe verwendet werden, mit einer Konzentrations- und Temperatursteuerung der Reaktionsgase zwischen der Quelle und dem Substrat zur Vermeidung einer Kondensation der Reaktionsgase vor dem oder den Substrat(en), **dadurch gekennzeichnet, dass** die von einem Tank (1,3) gebildete Quelle, insbesondere Sublimationsquelle, die Reaktionskammerwände (37) und die Gaseinlaßeinheit (15) auf jeweils höheren Temperaturen als das oder die Substrat(e) gehalten werden und die Ausgangsstoffe auf dem oder den Substrat(en) kondensieren.

2. Verfahren nach Anspruch 1, **dadurch gekennzeichnet, dass** eine Gaseinlaseinheit (15) mit einer Einlassgeometrie verwendet wird, die für eine Trennung der Gase zur Unterdrückung einer parasitären Gasphasenreaktion sorgt.

3. Verfahren nach einem oder mehreren der vorhergehenden Ansprüche, **dadurch gekennzeichnet, dass** die Quellen (1, 3) auf unterschiedlichen Temperaturen gehalten werden.

4. Verfahren nach einem oder mehreren der vorhergehenden Ansprüche, **gekennzeichnet durch** die Verwendung mehrerer Injektionsanordnungen (25, 26).

5. Verfahren nach einem oder mehreren der vorhergehenden Ansprüche, **dadurch gekennzeichnet, dass** zur Minimierung der parasitären Deposition und damit der Verluste aus der Gasphase die einzelnen Reaktionsgase ohne Strömungsüberlappung injiziert werden.

6. Verfahren nach einem oder mehreren der vorhergehenden Ansprüche, **dadurch gekennzeichnet, dass** die Austrittsgeschwindigkeit der Gase aus den einzelnen Injektionsdüsen sowie Injektionsbereichen so gewählt sind, dass lokale Bernoulli-Effekte vermieden werden.

7. Verfahren nach einem oder mehreren der vorhergehenden Anspräche, **dadurch gekennzeichnet, dass** der Druck in dem oder den Tanks (1, 3) der Ausgangsstoffe jeweils mittels Inertgasspülung (35) und Regelventil (34) unabhängig vom Druck in der Reaktorkammer (11) geregelt wird.

8. Vorrichtung zur Beschichtung eines Substrats mit einer Schicht mit
- einer Reaktionskammer (11)
- wenigstens einem Suszeptor (13) und
- einem Gaszuführungssystem (5,5') mit wenigstens einer Quelle für die Ausgangsstoffe und einer Gaseinlaßeinheit (15), wobei der oder die Suszeptor(en) (13) und die Reaktionskammerwände (37) separat thermostatisierbar sind, **dadurch gekennzeichnet, dass** die Quellen von die festen oder flüssigen Ausgangsstoffe bevorratenden Tanks (1, 3) gebildet sind und die Reaktionskammerwände (37), die Gaseinlaßeinheit (15) und die Tanks (1, 3) auf jeweils höhere Temperaturen als ein Substrat (12) auf dem Suszeptor (13) regelbar sind, so dass die aus der Gaseinlaßeinheit (15) austretenden Gase auf dem Substrat kondensieren.

9. Vorrichtung nach einem oder mehreren der vorhergehenden Ansprüche, **dadurch gekennzeichnet, dass** die Quellen (1, 3) getrennt thermostatisierbar sind, so dass ein positiver Temperaturgradient zu allen Kammer- und Einlassoberflächen einstellbar ist, und dass über Druck und Temperatur die Transportmenge der gasförmigen Ausgangsstoffe kontrollierbar ist.

10. Vorrichtung nach einem oder mehreren der vorhergehenden Ansprüche, **dadurch gekennzeichnet, dass** die Thermostatisierung eines oder aller Reservoire (1, 3) mittels einer Flüssigkeit oder elektrisch aktiven Komponenten ausgeführt ist.

11. Vorrichtung nach einem oder mehreren der vorhergehenden Ansprüche, **dadurch gekennzeichnet, dass** die Heizung derart ausgelegt ist, dass eine Reinigung eines Reservoirs durch gegenüber Prozesstemperatur erhöhte Temperatur möglich ist.

12. Vorrichtung nach einem oder mehreren der vorhergehenden Ansprüche, **dadurch gekennzeichnet, dass** die Gaseinlasseinheit (15) als Ein- oder Mehrkammer-Showerhead mit einem oder mehreren separaten Pleni (Volumen 22, 23) ausgebildet ist.

13. Vorrichtung nach einem oder mehreren der vorhergehenden Ansprüche, **dadurch gekennzeichnet, dass** als Trägergas Ar, H₂, N₂, He einzeln oder gemischt eingesetzt wird.

14. Vorrichtung nach einem oder mehreren der vorhergehenden Ansprüche, **dadurch gekennzeichnet, dass** ein gasförmiger Ausgangsstoff je Plenum (22, 23) separat über Düsen (25, 26) in die Reaktorkammer (11) einleitbar ist, so dass sich die Quellmaterialien erst nach Austritt aus dem Gaseinlass insbesondere kurz vor dem Substrat (12) vermischen können.

15. Vorrichtung nach einem oder mehreren der vorhergehenden Ansprüche, **dadurch gekennzeichnet, dass** zwei oder mehr gasförmige Ausgangsstoffe je Plenum (22, 23) separat über Düsen (25, 26) in die Reaktionskammer eingeleitet werden.

16. Vorrichtung nach einem oder mehreren der vorhergehenden Ansprüche, **dadurch gekennzeichnet, dass** die Düsen (25, 26) je Plenum gegenüber dem Substrat (12) in einem beliebigen Winnkel angeordnet sind.

17. Vorrichtung nach einem oder mehreren der vorhergehenden Ansprüche, **dadurch gekennzeichnet, dass** die Düsen (25, 26) je Plenum (22, 23) gleichen oder unterschiedlichen Durchmessern ausgeführt sind, so dass gleich oder unterschiedlich viskose Massenflüsse der Ausgangsstoffe eine homogene Injektionsverteilung sicherstellen.

18. Vorrichtung nach einem oder mehreren der vorhergehenden Ansprüche, **dadurch gekennzeichnet, dass** die Düsen (25, 26) je Plenum in gleichem oder unterschiedlichem Abstand zueinander in einer Verteilung so ausgeführt sind, dass sich eine homogene geschlossene Injektionsverteilung ergibt.

19. Vorrichtung nach einem oder mehreren der vorhergehenden Ansprüche, **dadurch gekennzeichnet, dass** jedes Plenum (22, 23) separat thermostatisierbar ist, so dass stark unterschiedliche sublimierende Ausgangsstoffe eingesetzt werden können.

20. Vorrichtung nach einem oder mehreren der vorhergehenden Ansprüche, **dadurch gekennzeichnet, dass** die Thermostatisierung eines oder aller Pleni (22, 23) mittels Flüssigkeit oder elektrisch aktiven Komponenten (30, 32) erfolgt, und dass die Kondensation der Ausgangsstoffe in jedem Plenum (22, 23) vermieden wird.

21. Vorrichtung nach einem oder mehreren der vorhergehenden Ansprüche, **dadurch gekennzeichnet, dass** Sensoren (38) und zugehörige Kanäle (39) in der Reaktorwandung vorgesehen sind, die Bemessung von Eigenschaften der Schichten und/oder auf der Oberfläche der Substrate (12) erlauben.

22. Vorrichtung nach einem oder mehreren der vorhergehenden Ansprüche, **dadurch gekennzeichnet, dass** der oder die Suszeptoren (13) zur Aufnahme von Substraten (12) mit runder, eckiger, flacher, gewölbter Form oder von Folien ausgebildet sind.

23. Vorrichtung nach einem oder mehreren der vorhergehenden Ansprüche, **dadurch gekennzeichnet, dass** der Suszeptor (13) mittels einer Flüssigkeit in einem Hohlmantel (14) oder elektrisch aktiven Komponenten (Peltier/Widerstandsheizung) thermisch so steuerbar ist, dass zwischen der die Suszeptoroberfläche und allen anderen Wänden (37) sowie der Gasphase einen negativen Temperaturgradienten besteht, so dass die Beschichtung des Substrats über Kondensation kontrollierbar werden kann.

24. Vorrichtung nach einem oder mehreren der vorhergehenden Ansprüche, **dadurch gekennzeichnet, dass** eine Heizung für den Suszeptor (13) derart ausgelegt ist, dass eine Reinigung des Suszeptors (13) und der Reaktionskammer (11) durch gegenüber der Prozesstemperatur erhöhte Temperatur durchgeführt werden kann.

25. Vorrichtung nach einern oder mehreren der vorhergehenden Ansprüche, **dadurch gekennzeichnet, dass** durch Verdünnung des aus den Tanks (1, 3) austretenden Gas mit einem Trägergas (35) die Konzentration des Ausgangsstoffes in der Rohrleitung (6) bzw. der Gaseinlasseinheit (15) derartig herabgesetzt wird, dass die Kondensationstemperatur unterhalb der Quellentemperatur liegt.

26. Vorrichtung nach einem oder mehreren der vorhergehenden Ansprüche, **dadurch gekennzeichnet, dass** das Substrat während des Beschichtungsvorganges maskiert ist, bspw. ,mit einer Schattenmaske versehen ist.

27. Vorrichtung nach einem oder mehreren der vorhergehenden Ansprüche, **dadurch gekennzeichnet, dass** zur Vermeidung abrupter Massenstromveränderung die geregelten Massenflüsse zu den Tanks (1, 3) in eine Bypassleitung (44) umgelenkt werden können.

## Claims

1. Method for coating substrates, in which, in a reaction chamber, a layer is applied to the at least one substrate, which is supported by a susceptor, by means of a condensation process as a result of reaction gases being introduced into the reaction chamber through a gas inlet unit (15), and in which solid and/or liquid starting materials are used for at least some of the reaction gases, with concentration and temperature control of the reaction gases between the source and the substrate in order to avoid condensation of the reaction gases before they reach the substrate(s), **characterized in that** the source, in particular sublimation source, which is formed by a tank (1, 3), the reaction chamber walls (37) and the gas inlet unit (15) are in each case held at higher temperatures than the substrate(s), and the starting materials condense on the substrate(s).

2. Method according to Claim 1, **characterized in that** a gas inlet unit (15) with an inlet geometry which ensures separation of the gases in order to suppress a parasitic vapour phase reaction is used.

3. Method according to one or more of the preceding claims, **characterized in that** the sources (1, 3) are held at different temperatures.

4. Method according to one or more of the preceding claims, **characterized by** the use of a plurality of injection arrangements (25, 26).

5. Method according to one or more of the preceding claims, **characterized in that**, to minimize the parasitic deposition and therefore the losses from the vapour phase, the individual reaction gases are injected without any flow overlap.

6. Method according to one or more of the preceding claims, **characterized in that** the outlet velocity of the gases from the individual injection nozzles and injection regions are selected in such a way that local Bernoulli effects are avoided.

7. Method according to one or more of the preceding claims, **characterized in that** the pressure in the tank(s) (1, 3) for the starting materials is in each case regulated independently of the pressure in the reactor chamber (11) by means of inert-gas purging (35) and regulating valve (34).

8. Device for coating a substrate with a layer, having
- a reaction chamber (11),
- at least one susceptor (13), and
- a gas supply system (5, 5') having at least one source for the starting materials and a gas inlet unit (15), it being possible for the susceptor(s) (13) and the reaction chamber walls (37) to be thermostated separately, **characterized in that** the sources are formed by tanks (1, 3) which store the solid or liquid starting materials, and the reaction chamber walls (37), the gas inlet unit (15) and the tanks (1, 3) can be regulated to in each case higher temperatures than a substrate (12) on the susceptor (13), so that the gases emerging from the gas inlet unit (15) condense on the substrate.

9. Device according to one or more of the preceding claims, **characterized in that** the sources (1, 3) can be thermostated separately, so that a positive temperature gradient can be set for all chamber and inlet surfaces, and **in that** the quantity of gaseous starting materials which is transported can be adjusted by means of pressure and temperature.

10. Device according to one or more of the preceding claims, **characterized in that** the thermostatting of one or all of the reservoirs (1, 3) is carried out by means of a liquid or electrically active Components,

11. Device according to one or more of the preceding claims, **characterized in that** the heating is designed in such a manner that cleaning of a reservoir is possible by using a temperature which is higher than the process temperature.

12. Device according to one or more of the preceding claims, **characterized in that** the gas inlet unit (15) is designed as a single-chamber or multichamber showerhead with one or more separate plenums (volumes 22, 23).

13. Device according to one or more of the preceding claims, **characterized in that** the carrier gas used is Ar, H₂, N₂, He individually or mixed.

14. Device according to one or more of the preceding claims, **characterized in that** one gaseous starting material per plenum (22, 23) can be introduced into the reactor chamber (11) separately via nozzles (25, 26), so that the source materials can only mix after they have emerged from the gas inlet, in particular just before reaching the substrate (12).

15. Device according to one or more of the preceding claims, **characterized in that** two or more gaseous starting materials per plenum (22, 23) are introduced into the reaction chamber separately via nozzles (25, 26).

16. Device according to one or more of the preceding claims, **characterized in that** the nozzles (25, 26) for each plenum are arranged at any desired angle with respect to the substrate (12).

17. Device according to one or more of the preceding claims, **characterized in that** the nozzles (25, 26) for each plenum (22, 23) are formed to have identical or different diameters, so that mass flows of the starting materials which have an identical or different viscosity ensure a homogeneous injection distribution.

18. Device according to one or more of the preceding claims, **characterized in that** the nozzles (25, 26) for each plenum are provided at identical or different distances from one another, in a distribution which is such that a homogeneous, continuous injection distribution results.

19. Device according to one or more of the preceding claims, **characterized in that** each plenum (22, 23) can be thermostated separately, so that starting materials which sublime to different extents can be used.

20. Device according to one or more of the preceding claims, **characterized in that** the thermostatting of one or all of the plenums (22, 23) takes place by means of liquid or electrically active components (30, 32), and **in that** the condensation of the starting materials is avoided in each plenum (22, 23).

21. Device according to one or more of the preceding claims, **characterized in that** sensors (38) and associated passages (39) are provided in the reactor wall, making it possible to measure properties of the layers and/or on the surface of the substrates (12).

22. Device according to one or more of the preceding claims, **characterized in that** the susceptor(s) (13) are formed to accommodate substrates (12) with a round, polygonal, flat, or curved shape or sheets.

23. Device according to one or more of the preceding claims, **characterized in that** the susceptor (13) can be thermally controlled, by means of a liquid in a hollow jacket (14) or electrically active components (Peltier/resistance heating) in such a way that there is a negative temperature gradient between the susceptor surface and all other walls (37) and the vapour phase, so that the coating of the substrate by means of condensation can be adjusted.

24. Device according to one or more of the preceding claims, **characterized in that** a heater for the susceptor (13) is configured in such a manner that cleaning of the susceptor (13) and of the reaction chamber (11) can be carried out by means of a temperature which is higher than the process temperature.

25. Device according to one or more of the preceding claims, **characterized in that**, through dilution of the gas emerging from the tanks (1, 3) with a carrier gas (35), the concentration of the starting material in the pipeline (6) or the gas inlet unit (15) is reduced to such an extent that the condensation temperature is lower than the source temperature.

26. Device according to one or more of the preceding claims, **characterized in that** the substrate is masked during the coating operation, for example is provided with a shadow mask.

27. Device according to one or more of the preceding claims, **characterized in that**, to avoid an abrupt change in mass flow, the regulated mass flows to the tanks (1, 3) can be diverted into a bypass line (44).

## Revendications

1. Procédé d'enduction de substrats, pour lequel, dans une chambre de réaction, au moyen d'un procédé par condensation, par introduction de gaz de réaction via une unité d'introduction de gaz (15) dans la chambre de réaction, une couche est appliquée sur le au moins un substrat soutenu par un suscepteur, et pour lequel, pour au moins une partie des gaz de réaction, des substances de départ solides et / ou liquides sont utilisées, avec une commande de concentration et de température des gaz de réaction entre la source et le substrat pour éviter une condensation des gaz de réaction avant le ou les substrat(s), **caractérisé en ce que** la source formée par un réservoir (1, 3), en particulier une source de sublimation, les parois de la chambre de réaction (37) et l'unité d'introduction de gaz (15) sont maintenues respectivement à des températures supérieures à celle du ou des substrat(s), et **en ce que** les substances de départ se condensent sur le ou les substrat(s).

2. Procédé selon la revendication 1, **caractérisé en ce qu'**une unité d'introduction de gaz (15) est utilisée, avec une géométrie d'entrée qui assure une séparation des gaz pour inhiber une réaction parasite en phase gazeuse.

3. Procédé selon l'une ou plusieurs des revendications précédentes, **caractérisé en ce que** les sources (1, 3) sont maintenues à des températures différentes.

4. Procédé selon l'une ou plusieurs des revendications précédentes, **caractérisé par** l'utilisation de plusieurs dispositifs d'injection (25, 26).

5. Procédé selon l'une ou plusieurs des revendications précédentes, **caractérisé en ce que**, pour la minimisation des dépôts parasites et ainsi des pertes depuis la phase gazeuse, les différents gaz de réaction sont injectés sans chevauchement des écoulements.

6. Procédé selon l'une ou plusieurs des revendications précédentes, **caractérisé en ce que** les vitesses de sortie des gaz depuis les différentes buses d'injection et domaines d'injection sont choisies de telle sorte que les effets de Bemouilli locaux soient évités.

7. Procédé selon l'une ou plusieurs des revendications précédentes, **caractérisé en ce que** la pression dans le ou les réservoirs (1, 3) des substances de départ est régulée respectivement au moyen d'un balayage à gaz inerte (35) et d'une valve de régulation (34), indépendamment de la pression dans la chambre de réaction (11).

8. Dispositif d'enduction d'un substrat avec une couche, avec
- une chambre de réaction (11)
- au moins un suscepteur (13)
- un système d'amenée de gaz (5, 5') avec au moins une source pour les substances de départ et une unité d'introduction de gaz (15), dans lequel le ou les suscepteur(s) (13) et les parois de la chambre de réaction (37) sont thermostatables séparément, **caractérisé en ce que** les sources sont constituées par des réservoirs (1, 3) stockant les substances de départ solides ou liquides, **en ce que** les parois de la chambre de réaction (37), l'unité d'introduction de gaz (15) et les réservoirs (1, 3) peuvent être régulés à des températures respectives plus élevées qu'un substrat (12) sur le suscepteur (13), de telle sorte que les gaz sortant de l'unité d'introduction de gaz (15) se condensent sur le substrat.

9. Dispositif selon l'une ou plusieurs des revendications précédentes, **caractérisé en ce que** les sources (1, 3) sont thermostatables séparément, de telle sorte qu'on peut régler un gradient de température positif à toutes les surfaces de la chambre et de l'entrée, et qu'on peut contrôler le débit des substances de départ gazeuses transportées par l'intermédiaire de la pression et de la température.

10. Dispositif selon l'une ou plusieurs des revendications précédentes, **caractérisé en ce que** le thermostatage d'un ou de tous les réservoirs (1, 3) est effectué au moyen d'un liquide ou de composants électriquement actifs.

11. Dispositif selon l'une ou plusieurs des revendications précédentes, **caractérisé en ce que** le chauffage est conçu de telle sorte qu'un nettoyage d'un réservoir est possible par une température accrue en comparaison de la température de process.

12. Dispositif selon l'une ou plusieurs des revendications précédentes, **caractérisé en ce que** l'unité d'introduction de gaz (15) est configurée comme tête de douche à un ou à plusicurs compartiments, avec un ou plusieurs plénums (volumes 22, 23) séparés.

13. Dispositif selon l'une ou plusieurs des revendications précédentes, **caractérisé en ce que** Ar, H₂, N₂ et He sont utilisés comme gaz vecteurs, purs ou en mélanges.

14. Dispositif selon l'une ou plusieurs des revendications précédentes, **caractérisé en ce qu'**une substance gazeuse de départ par plénum (22, 23) peut être introduite séparément dans la chambre de réaction (11) par des buses (25, 26), de telle sorte que les matériaux sources ne peuvent se mélanger qu'après leur sortie de l'admission de gaz, en particulier peu avant le substrat (12).

15. Dispositif selon l'une ou plusieurs des revendications précédentes, **caractérisé en ce que** deux substances de départ gazeuses ou plus par plénum (22, 23) sont introduites séparément dans la chambre de réaction par des buses (25, 26).

16. Dispositif selon l'une ou plusieurs des revendications précédentes, **caractérisé en ce que** les buses (25, 26) par plénum sont disposées sous un angle quelconque par rapport au substrat (12).

17. Dispositif selon l'une ou plusieurs des revendications précédentes, **caractérisé en ce que** les buses (25, 26) par plénum (22, 23) sont réalisées de mêmes diamètres ou de diamètres différents, de telle sorte que des écoulements massiques de viscosités égales ou différentes des substances de départ assurent une répartition homogène de l'injection.

18. Dispositif selon l'une ou plusieurs des revendications précédentes, **caractérisé en ce que** les buses (25, 26) par plénum, à même distance ou à distance différente les unes des autres, sont exécutées dans une répartition de telle sorte qu'il s'ensuit une répartition homogène fermée de l'injection.

19. Dispositif selon l'une ou plusieurs des revendications précédentes, **caractérisé en ce que** chaque plénum (22, 23) est thermostatable séparément, de telle sorte que des substances de départ sublimables fortement différentes peuvent être utilisées.

20. Dispositif selon l'une ou plusieurs des revendications précédentes, **caractérisé en ce que** le thermostatage d'un ou de tous les plénums (22, 23) s'effectue au moyen d'un liquide ou de composants électriquement actifs (30, 32), et **en ce que** la condensation des substances de départ dans chaque plénum (22, 23) est évitée.

21. Dispositif selon l'une ou plusieurs des revendications précédentes, **caractérisé en ce que** des capteurs (38) et des canaux correspondants (39), qui permettent des mesures de propriétés des couches et / ou des mesures à la surface des substrats (12), sont prévus dans la paroi du réacteur.

22. Dispositif selon l'une ou plusieurs des revendications précédentes, **caractérisé en ce que** le ou les suscepteurs (13) est (sont) configuré(s) pour la réception de substrats (12) de forme ronde, anguleuse, plate ou bombée, ou de films.

23. Dispositif selon l'une ou plusieurs des revendications précédentes, **caractérisé en ce que** le suscepteur (13) peut être commandé thermiquement au moyen d'un liquide dans une enveloppe creuse (14) ou de composants électriquement actifs (Peltier / chauffage à résistance), de telle sorte qu'entre la surface du suscepteur et toutes les autres parois (37), ainsi que la phase gazeuse, il y a un gradient de température négatif, de telle sorte que l'enduction du substrat peut devenir contrôlable via la condensation.

24. Dispositif selon l'une ou plusieurs des revendications précédentes, **caractérisé en ce qu'**un chauffage est conçu pour le suscepteur (13), de telle sorte qu'un nettoyage du suscepteur (13) et de la chambre de réaction (11) peuvent être effectués par une température accrue en comparaison de la température de process.

25. Dispositif selon l'une ou plusieurs des revendications précédentes, **caractérisé en ce que**, par dilution du gaz sortant des réservoirs (1, 3) avec un gaz vecteur (35), la concentration de la substance de départ dans la tuyauterie (6), respectivement dans l'unité d'introduction de gaz (15), est abaissée dans une mesure telle que la température de condensation se trouve en dessous de la température de la source.

26. Dispositif selon l'une ou plusieurs des revendications précédentes, **caractérisé en ce que**, pendant le processus d'enduction, le substrat est masqué, par exemple doté d'un masque faisant ombre portée.

27. Dispositif selon l'une ou plusieurs des revendications précédentes, **caractérisé en ce que**, pour l'évitement de variations abruptes du débit massique, les écoulements de masse régulés vers les réservoirs (1, 3) peuvent être détournés dans une conduite de dérivation (44).
